# EUROPEAN PATENT APPLICATION

(11) **EP 2 998 038 A1**
(43) Date of publication of application: **23.03.2016**
(21) Application number: 15185389.2
(22) Date of filing: 16.09.2015
(51) Int. Cl.: B09B 3/00, B09B 5/00, H01L 31/18

(54) **METHOD AND APPARATUS FOR DETACHING GLASS FORM A MONO- OR POLYCRYSTALLINE SILICON-BASED PHOTOVOLTAIC PANEL**

(30) Priority: 16.09.2014 IT TO20140730
(71) Applicant: SASIL S.p.A., 13862 Brusnengo (Biella) (IT)
(72) Inventor: ERCOLE, Pietro, I-14100 ASTI (IT); RAMON, Lodovico, I-13862 BRUSNENGO (Biella) (IT); AGNOLETTI, Olimpia, I-30172 MESTRE (Venezia) (IT)
(74) Representative: Vanzini, Christian

(57) **Abstract**

Process for separating glass from a photovoltaic panel laminate, the laminate comprising an encapsulating layer (3) of partly cross-linked ethylene vinyl acetate, EVA, and containing photovoltaic cells of mono- or polycrystalline metallic silicon, a front plate (5) of glass and a back sheet (7) bonded to the encapsulating layer on opposite surfaces thereof. The process comprises the stages of:
heating the laminate (1) by infrared heaters (R1, R2) to raise the EVA to a working temperature of between 70 and 150°C in order to cause it to soften; and
removing the glass from the encapsulating layer (3) heated to the working temperature.

## Description

This invention relates in general to methods for the recovery of materials present in scrap photovoltaic panels.

It is known that 90% of the photovoltaic cells now in operation use metallic silicon, in particular in a mono- or polycrystalline form, and that only 45-50% of the silicon consumed to produce them is converted into the wafers inserted in them, while the difference is lost in waste from the cutting process mixed with silicon carbide (SiC, the abrasive material used).

Although the production of first-generation photovoltaic cells began approximately 30 years ago, and the quantity of crystalline metallic silicon scrap lost in the processing of ingots was 102,000 tonnes in 2010, with a value of approximately fifty thousand million dollars, no process for its recovery has yet been developed.

It should also be borne in mind that the chemical process for obtaining silicon ingots for photovoltaic cells from SiO₂ requires very high temperatures (>2000°C) and therefore requires very large energy consumption (100 MW/hour per tonne), while recovery and recycling of the crystalline silicon present in worn-out units can, in principle and potentially, be carried out using approximately 5% of that used in the primary process.

Finally it should be borne in mind that, according to estimates made in 2006, approximately 48 tonnes of CO₂ are emitted in the production of 1 metric ton of silicon ingots of metallurgical quality (low purity), while in order to obtain the same quantity in monocrystalline form (very high purity) emissions rise to as much as 62 metric tons.

These objective findings suggest that in order to make a significant reduction in the cost of the electrical energy used for photovoltaic cells while reducing the environmental impact mentioned above, it is not enough to recover the silicon lost in cutting wafers from ingots but it is essential to recover all the materials present in photovoltaic cells, including the silicon, at a level of quality which at least allows them to be reused.

All the processes suggested hitherto have run into a number of difficulties during the stage of separating off EVA (ethylene vinyl acetate). This has resulted in solutions which are imperfect, complex and have an outcome which is insufficiently certain to compromise both upscaling to industrial level and the opening up of a practical route to obtaining directly reusable metallic silicon.

It is worthwhile pointing out that this problem is caused by the fact that the EVA, which is applied hot (150°C) when the panels are manufactured, is mostly cured (approximately 70%), and does not therefore behave uniformly, above all during extraction with solvents of various kinds.

The problem of recovery and reuse of the useful components present in scrap photovoltaic units has been tackled with various techniques which can be subdivided into two groups.

### a. Extraction of EVA with organic and inorganic solvents

This technique is based on various solutions providing for treatment with both inorganic and organic solvents which should make it possible to recover the various components, and especially silicon, noble metal conductors (silver and silver/aluminium alloys) and flat glass at a level of quality which should make it possible for them to be recycled and/or reused.

Most of these processes are intended to recover intact decontaminated silicon wafers which can be directly recycled in the manufacture of new units, a solution which is very attractive from the economical and environmental point of view but which in the present state of the art is so complex and difficult as to be impossible to implement. These processes are in fact complicated by a very different set of chemical treatments (complex mixtures of acids and other components) which have the specific function of removing extraneous elements in order to achieve the necessary purity for direct recycling.

Another complication derives from the fact that the suitability of wafers which are recovered intact cannot be established analytically or by using the most up-to-date instrumental methods, but must be determined by evaluating the efficiency of a unit which has been reconstructed using the recovered wafers in comparison with that of original units.

Other processes on the other hand are only intended to reuse the silicon, the glass and the conductors, partly comprising noble metals, for applications which require lesser and more easily achievable quality specifications. In this respect simplified processes based on chemical dissolution have been proposed for extraction of the EVA (saponification of the ester groups through the action of an alkaline solution) or using ultrasound to assist the action of an organic solvent.

There are therefore many difficulties associated with the application of these technologies:
- the uncertain outcome of EVA extraction with solvents;
- contamination of the metallic silicon caused by the migration of metals (silver and aluminium) transported by the solvent to a small extent but sufficient to compromise the efficiency of regenerated photovoltaic cells;
- the complexity of treatments with acids to extract contaminating ions from mono- or polycrystalline metallic silicon wafers;
- the technological and environmental complications which have to be overcome in order to recover solvents and to treat the gaseous and liquid discharges resulting from the use of solvents;
- the unachievable need to obtain a mechanical yield (undamaged cells) which is sufficient to justify use of the various complicated systems.

All the solutions intended to remove EVA which make use of extraction with organic and/or inorganic solvents have therefore yielded equivocal results which are sufficiently uncertain as not to allow reliable upgrading to an industrial scale.

In addition to this there is no information demonstrating the implementation of the various solutions offered nor any significant small-scale tests, or even long-term continuous tests in a pilot plant.

### b. Thermal decomposition of the EVA using various techniques to produce recyclable wafers and/or silicon and glass which can be used in various processes

In the present state of knowledge the most reliable technology for the complete removal of EVA is thermal decomposition carried out on a batch basis through pyrolysis in an inert atmosphere (nitrogen) or combustion.

Batch pyrolysis in an inert environment makes it possible to recover cracking products which when fed to a burner provide the energy necessary to sustain the endothermic reactions for the pyrolysis itself, and by prolonging the thermal treatment make it possible to obtain siliceous ashes free from EVA.

For thermal balance reasons both the pyrolysis and combustion of EVA must be carried out on material which is completely free from glass, which would absorb heat, increasing the cost of the operation.

A third way of decomposing EVA through continuous pyrolysis provides for the use of a fluidised bed reactor produced by dispersing very fine siliceous sand (100 microns) of very uniform particle size.

Abrasion by the fine sand against the EVA helps to release the gases produced by thermal cracking of the polymer which are passed to a burner outside the pyrolysis chamber.

In batch pyrolysis in an inert environment (nitrogen) the reaction is completed in a time of 90 minutes at a temperature of 520°C, which in the absence of combustion is sufficiently constant for all the surfaces involved.

Direct combustion of EVA makes it possible to complete the reaction at a temperature of 540°C in a time of the order of 60 minutes, although the exothermic reactions of combustion give rise to localised overheating of the silicon surface, whose temperature can rise to levels of 580-590°C.

In the third process the fluidised bed produced using fine uniform siliceous sand accelerates the pyrolysis and makes it possible to complete the reaction in a time of 30 minutes at a temperature of 450-470°C.

It should however be borne in mind that the processes which remove EVA by thermal decomposition also give rise to the migration of metal ions into the silicon. Therefore here again if it is intended to recover wafers which can be directly reused it will be necessary to treat them with mixtures of acids of various complexity.

In order to avoid the difficulties with the recovery of materials from panels containing EVA, solutions that use other copolymers as an encapsulating agent which have optical characteristics identical to those of EVA, but which are characterised by the absence of double bonds and are therefore capable of maintaining thermoplasticity over time, have recently been proposed.

Clearly this does not solve the problem of recovery and reuse of the materials present in existing photovoltaic units which have reached the end of their life, or which will do so within a few years.

This situation therefore makes it necessary to develop solutions which will both reduce the waste of non-reusable materials and make it possible to convert all the others into secondary raw materials for use in primary industries, and partly indirectly recycled to the photovoltaic industry.

This invention has in particular the object of providing a process for the removal of glass from photovoltaic panels which makes it possible to recover high quality glass that is substantially free of metallic silicon.

Another object of this invention is to provide a process for the removal of glass from photovoltaic panels which does not make use of solvents to dissolve the EVA.

In view of these aims the object of the invention is a process for separating glass from a photovoltaic panel laminate, the said laminate comprising an encapsulating layer with partly cured vinyl acetate, EVA, and containing mono- or polycrystalline metallic silicon photovoltaic cells, a front plate of glass and a back sheet bonded to the said encapsulating layer on opposite surfaces thereof, characterised in that it comprises the stages of:
heating the laminate by means of infrared lamps to bring the EVA to a working temperature between 70 and 150°C, preferably between 100 and 110°C, to cause the EVA to soften; and
detaching the glass from the encapsulating layer heated to the working temperature.

This invention derives from the finding that the EVA present in scrap photovoltaic panels generally has residual thermoplasticity due to the presence of a significant fraction of the initial unsaturation in the virgin polymer, which is therefore significantly but not wholly cured after the process of manufacturing the original panels (Hsu Y. et al., Thermoanalytical Characterization of Ethylene Vinyl Acetate (EVA) for Lamination Process Simulation and Gel Content Determination in Photovoltaic Modules, 2012 PV Module Reliability Workshop, Golden, Colorado, 28 February - 1st March, 2012, Denver Marriott West, NREL, USA; Hirschl et al., Determining the degree of crosslinking of ethylene vinyl acetate photovoltaic module encapsulants - A comparative study, Solar Energy Materials and Solar Cells 116 (2013) 203-218).

Knowledge of the extent to which the reaction for curing the EVA present in the panels at the end of their life has gone to completion therefore makes it possible to determine the time available at various temperature levels to prevent excessive hardening of the EVA during removal of the glass, which would obviously hinder the operation.

In addition to this it is possible to set the working temperature at a level such as to prevent excessive softening of the back sheet, which generally comprises thermoplastic materials (generally polyethylene terephthalate, polyvinyl fluoride or polyvinyl chloride) and supports the entire structure of the cell. Excessive softening of the back sheet could in fact create continuity problems when processing the panels.

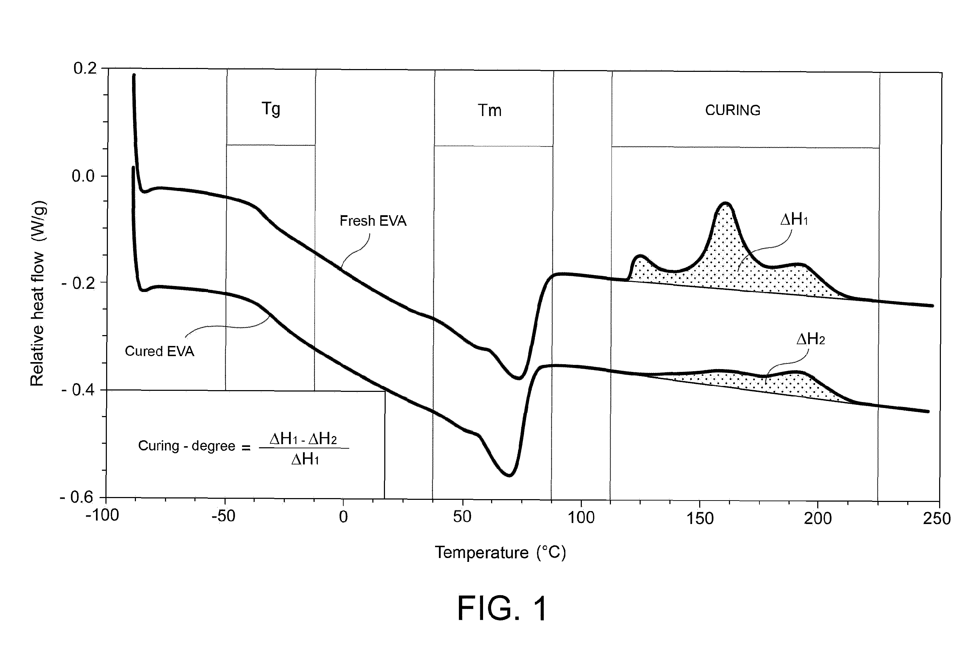

The graph in Figure 1, reported by Hsu Y. et al. (reference indicated above) shows differential calorimetry curves for two different types of EVA. The first (the upper curve) comprises a fresh polymer, that is to say one without cross-linking bonds, normally used by companies producing photovoltaic units based on mono- or polycrystalline metallic silicon, which because it has not yet been heated does not contain any transverse bonds between the molecules (cross-linking). The second (lower curve) comprises EVA extracted from a photovoltaic unit at the end of its life, in which a significant part of the curing reaction has taken place during production of the panel (injection of the polymer at a temperature of 120-150°C).

Both the samples were heated at a rate of 10°C/minute.

The progress of the curing reaction was defined by measuring the heat absorbed by the sample net of that emitted by the exothermic curing reaction.

The changes in heat emitted by the two samples shown on the ordinate axis explains the progress of the reaction under investigation and clearly define the temperature at which EVA begins to harden (approximately 110-120°C).

Comparison between the curves shows that both the materials absorb energy during heating (both the curves slope downwards); subsequently both the polymers emit energy during the fusion stage Tm inverting the slope of the two curves. This continues up to a temperature of 88-90°C.

The courses of the two curves mentioned above differ in that the upper curve shows two high peaks which are well separated from each other, while the red curve shows the same peaks, but shorter and flatter.

This indicates that the partly cured polymer still has cross-linking capacity of the order to 30-35%, compared with 100% for fresh polymer.

Following the progress of the graph completion of the reaction begins at a temperature of approximately 110-120°C and finishes at approximately 220°C.

The facts observed make it possible to draw the following favourable conclusions:
a. The course of the two curves, but in particular that relating to the EVA recovered from a scrap photovoltaic unit shows that when the material reaches 88-90°C it begins to melt, or better its viscosity reduces, but that within the range 90-120°C completion of the curing reaction has not yet been resumed. This situation makes it possible to state that it is possible to have the time required for facilitating removal of the EVA from the glass very satisfactorily without running the risk that curing might create problems.
b. It should in fact be borne in mind that the tests which have made it possible to construct the interesting graph described above were carried out with an EVA heating rate of 10°C/minute. In other words this means that the time required to raise the temperature to 120°C is of the order of 3 minutes, or that using a temperature below 120°C more time can be available for completing the removal operation.
c. These observations leave a wide margin of choice for both the working temperature, avoiding, as mentioned, softening of the back sheet comprising a thermoplastic material, creating continuity problems for the system, and time, making it possible to obtain productivity levels which are wholly compatible with the rhythms required for an industrial unit. In this respect it should be pointed out that tests carried out by the Applicant continuously on pilot apparatus provided with systems for controlling temperature and removal time have made it possible to remove EVA from glass with a production rate of the order of 1.0 m/minute working at a temperature of 100-110°C.
d. It has also been experimentally demonstrated that heating the EVA to a temperature of 100-110°C, held constant by a suitable regulation and control system, at which curing has either not yet begun or proceeds very slowly, the system can operate long-term without any particular reasons for interruption. In other words this means that quantitative removal of glass from the EVA can be carried out very readily. More generally, it is thought that the process could be carried out in a temperature range between 70 (the temperature around which EVA begins to become plastic) and 150°C (the temperature around which the curing process becomes excessively fast), although with lower efficiency.

Tests carried out through heating the panel (without the aluminium structure) using infrared lamps at different wavelengths demonstrate that the system works satisfactorily with low energy consumption, in that the glass does not absorb the heat issuing from the lamps and is only heated by conduction from the EVA, thus minimising the heat losses which would be greater if other sources of energy were to be used.

Preferred embodiments of the invention are defined in the dependent claims which are to be regarded as an integral part of this description.

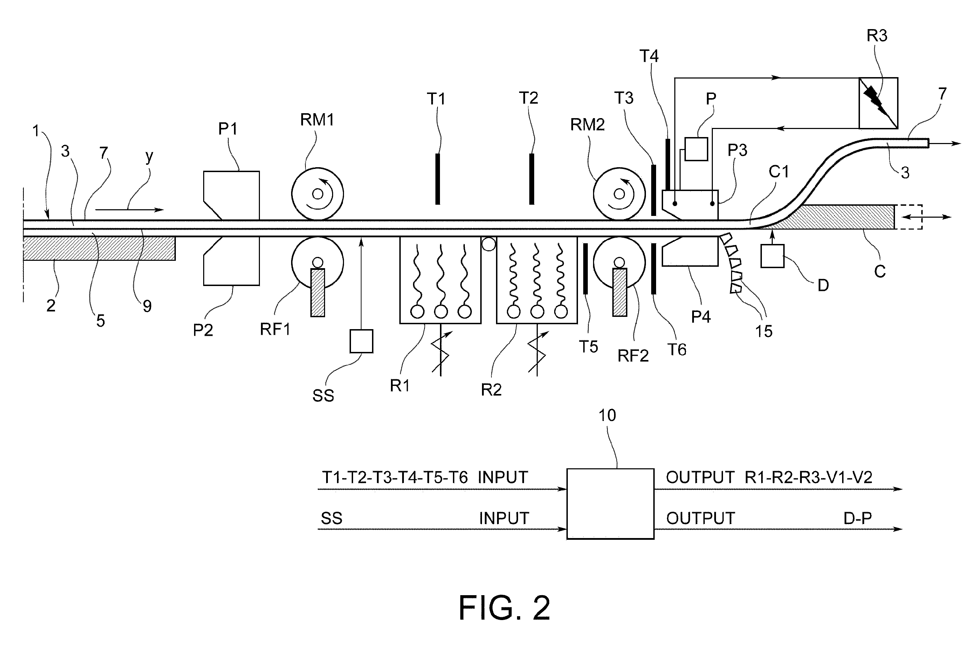

Further features and advantages of the process according to the invention will become more apparent from the following detailed description of an embodiment of the invention with reference to the appended drawings provided purely by way of illustration and without limitation, in which
Figure 2 is a diagram of a plant for implementing the process according to the invention.

A photovoltaic panel 1 is caused to advance along a direction of advance parallel to its surfaces. 2 indicates a supporting base provided to feed laminate 1 into the plant. With this object supporting base 2 is also assisted by opposing plates P1 and P2 in order to convey laminate 1. By "photovoltaic panel laminate" is meant the laminate material obtained from a photovoltaic panel once the other components (supporting frame, connectors, etc.) have been removed.

Laminate 1 conventionally comprises an encapsulating layer 3 of ethylene vinyl acetate (EVA) which is partly cured and contains mono- or polycrystalline metallic silicon photovoltaic cells (not illustrated), a front plate 5 of glass and a back sheet 7 bonded to encapsulating layer 3 on opposite surfaces of the latter. 9 indicates the interface between the glass and the EVA. The terms "front plate" and "back sheet" derive from the conventional terminology used for photovoltaic panels, and relate to the positioning of the panel with respect to the solar radiation shining upon it when in use. These terms are not however intended to indicate the actual positioning of the panel in the context of the process according to the invention.

As may be seen in Figure 2, laminate 1 lies on supporting base 2 with its front plate surface, and therefore with the glass plate facing downwards.

Movement of laminate 1 is provided by two successive pairs of rollers RM1, RF1; RM2, RF2, each of which comprises a drive roller and an idling roller which respectively engage the opposite surfaces of laminate 1.

A thickness measurer SS is also provided to measure the total thickness of laminate 1.

Two sets of infrared heaters R1, R2, with long wavelengths and short wavelengths respectively, are located along the route along which laminate 1 moves to progressively heat laminate 1 to raise the EVA to a working temperature of between 70 and 150°C, preferably between 100 and 110°C. The abovementioned heaters emit infrared radiation between 1000 and 2500 nm, in relation to which the glass front plate 5 is transparent. Temperature sensors T1 and T2 are located within the heating portion corresponding to heating units R1 and R2 respectively to measure the temperature of the surface of the back sheet of panel 1, and a temperature sensor T5 is located at the exit from the heating portion to measure the temperature of the surface of the front plate of panel 1.

A further pair of opposite plates P3, P4 to convey laminate 1 is located downstream from the heating portion.

At least one of these plates is heated by an insulating fluid fed from a feed circuit provided with a heater R3. This has the function of compensating for the fall in temperature of laminate 1 when in transit so that subsequent removal of the glass takes place at the desired working temperature. For this purpose temperature sensors T3, T6 are located at the entry to plates P3, P4 to determine the temperature of the surface of the back sheet and the surface of the front plate of panel 1 respectively, and a temperature sensor T4 is connected to plates P3, P4 to determine the temperature of the plates themselves. Movable positioner P is also associated with plates P3, P4 to adjust the distance between them according to the thickness of laminate 1.

At the exit from plates P3, P4 there is a transverse chisel C cutting into laminate 1 head-on (with respect to the direction of advance of the laminate) and capable of moving alternately in a direction parallel to the direction of progress y of laminate 1 to bring about removal of the glass in the form of fragments 15 which fall by gravity from the remaining part which mainly comprises the softened layer of EVA 3 (containing the photovoltaic cells) and back sheet 7. The Applicant has for example constructed a pilot plant with a chisel driven by cams capable of making 1500 thrusts/minute, with a rate of advance of the laminate of 1.0 m/minute.

On leaving the plant described above it is possible to obtain both glass, which depending upon its properties can be used as a secondary raw material in the glass industry or for other purposes, and a sandwich material comprising the layer of EVA 3 containing the photovoltaic cells and back sheet 7, with possibly residual glass remaining adhering to that sandwich. This sandwich material can be subsequently subjected to further thermal and/or chemical processing to recover the more valuable component materials (silicon and possibly the conducting metals).

With respect to the direction of the thickness of laminate 1, cutting edge C1 of the blade of transverse chisel C is positioned within the thickness of the glass close to interface 9 between glass and EVA. A movable spacer D is associated with chisel C to adjust the level of cutting edge C1 and chisel C with respect to laminate 1.

A control unit 10 is programmed to receive temperature signals T1, ..., T6 as an input and process them, and as a consequence to control the operation of infrared heaters R1, R2 and insulating fluid heater R3, the speed of rotation V1 of drive rollers RM1, RM2 and the thrust frequency V2 of chisel C. Control unit 10 is also programmed to receive the signal from thickness measurer SS as an input and process it in order to control adjustment of movable spacer D for the chisel and movable positioner P for conveyor plates P3, P4.

The infrared lamps having different wavelengths increase the temperature in a way which is controlled by a temperature-regulating loop which alters the supply of energy to the infrared lamps and therefore makes it possible to maintain the preset working temperature at all times and hold it substantially constant while the glass is being removed. Under these conditions the glass, which does not absorb the infrared light, is only heated by conduction from the EVA itself. The glass is discharged from the system at a substantially lower temperature, thus containing heat losses. The temperature gradient between the opposite surfaces of the laminate is between 5 and 35°C, preferably between 15 and 25°C.

Heated plates P3, P4 compensate for any fall in the temperature of the laminate when in transit so that the transverse chisel detaching the glass in small fragments (of the order of a millimetre) works at the same temperature which makes it possible to utilise the residual thermoplasticity of the polymer without encouraging completion of the curing.

The chisel moving with alternating motion therefore makes it possible to produce glass removed from laminate 1 continuously, at a rate determined by the rotation speed V1 of drive rollers RM1, RM2.

It should be pointed out that working at the temperatures indicated above the back sheet of thermoplastic material never reaches temperatures such as to undergo changes in viscosity which might compromise regular movement of the laminate, with consequent stoppages.

The transverse chisel must be positioned in such a way that the glass is detached from the EVA so that the greatest possible quantity is recovered (a suitable value could be approximately 98-99% of the glass present in the laminate) avoiding removal of even the slightest part of the underlying silicon, which if present in the glass product in traces would prejudice its use in furnaces for the production of flat glass having a very low concentration of Fe₂O₃. This is because the metallic silicon does not pass into solution during processing of the glass and leaves behind particles of silicon characterised by an expansion coefficient much greater than that of the glass, which would cause dangerous and unacceptable cracking on cooling, in the vitreous mass.

Positioning of the chisel must therefore be gauged according to the thickness of the glass plate, which may vary greatly in photovoltaic cells at the end of their life. Those hitherto observed by the Applicant have thicknesses within the range 2.5 to 4 mm. Consequently, in order to obtain recovery with the percentages indicated above the knife must be set to 3.92 mm in the case of the thickest and 2.47 mm in the case of the thinnest (values defined by setting 0 to correspond to the surface of the glass plate of the laminate).

The following working possibilities arise in the light of the above.
i. Selecting incoming panels into different categories of uniform thicknesses and feeding them to the plant in different runs so that the position of the chisel is set according to the category in use. This adjustment gives rise to the risk that particles of metallic silicon will be drawn up into the glass removed and therefore means that a solution must be developed to make it possible to remove all silicon particles (electronic optical equipment bringing about rejection when it detects the presence of a black particle of metallic silicon).
ii. Not selecting the incoming panels and gauging the panel at the smaller thickness (for example 2.5 mm). Here again the risk of drawing up metallic silicon particles into the removed glass is high and makes it necessary to use the optical selection of the glass produced described in the previous paragraph.
iii. As in the previous case, feeding the unselected panels according to the thickness of the glass but automatically reading the thickness of the glass using a suitable reader and automatically positioning the chisel in such a way as to remove 98-99% of the glass present.
iv. It should be pointed out that in the case where the sandwich material containing the EVA undergoes subsequent thermal processing the presence of glass in that material will make it necessary to deliver approximately 2% of the initial glass to pyrolysis with the EVA and the metallic silicon, therefore obtaining ashes contaminated by the presence of glass.
v. On the one hand this would in any case make it necessary to install optical selection for the metallic silicon present in the glass, and on the other hand, would make it possible to have experimental time to check whether it would be possible to reduce the glass contaminating the material delivered to pyrolysis to minimum levels by gradually lowering the position of the chisel and evaluate how much glass would be lost in optical selection of silicon present in the finished glass.

### Example 1

A suitable number of panels without aluminium frames were used in a test plant configured as described above and from these approximately 30 strips having the following dimensions, 135 cm x 25 cm, were recovered. Of these 27 were bonded head- to-tail obtaining a continuous strip approximately 36.5 m long which would guarantee operating continuity of the order of 60 minutes.

The end-of-life photovoltaic panels used in Example no. 1 were characterised by a glass having a low Fe₂O₃ content (<0.02%), and therefore a very low absorbance for infrared light in the range 1000-2500 nm. The thickness of the glass in the panels was 4.0 mm.

Heating the abovementioned strip with IR lamps of adequate power controlled by an algorithm controlling the thermal energy delivered and the temperature of the EVA and the glass it was possible, by also acting on the rate of feed in the system:
- To make use of the high transmittance of the glass towards the underlying layer of EVA, raising it to the temperature of 105°C ± 2° C at which it is possible to make use of the residual thermoplasticity of the EVA without initiating completion of curing, which begins at around 145°C,
- To maintain a gradient of 25°C between the temperature of the EVA and the overlying glass (EVA 105°C - glass 75°C), which is very important because it both clearly favours removal of the glass from the EVA and also reduces or even eliminates the extremely harmful carry-over of metallic silicon particles into the recovered glass,
- To avoid excessive heating of the material of the back sheet which in all its versions is a thermoplastic material and could curl up creating hold-ups which would be very harmful, both for the continuity of processing and for the long times which would be required to restore the system to operation, which would compromise the productivity of the plant.

The following results were obtained under these conditions:
1. The test was carried out for a little over 60 minutes feeding all 36.5 m of strip obtained in the manner described above.
2. Variations in the temperature of the glass of a maximum order of 3°C (70°C minimum and 75°C maximum) were recorded during the period while the temperatures of the glass varied over a range of 5°C (105°C minimum and 110°C maximum) with a gradient oscillating between values of 25°C and 30°C. No inconveniences worthy of note were observed.
3. The strip fed in contained 91.1 kg of glass while in the course of the entire test 88.8 kg were recovered, giving a yield of the order of 97.48%.

Two samples were taken during the period, the first after 30 minutes operation of the prototype and the second after 50 minutes.

The results for Example no. 1 are summarised in Table 1 below.

**Table 1**

| **Results obtained** | |
|---|---|
| Length of the photovoltaic strip m | 36.5 |
| Temperature of the EVA + silicon °C | 105-110°C |
| Temperature of the glass °C | 80-85°C |
| Gradient between the two temperatures °C | 25-35°C |
| Duration of the test minutes | 62 |
| Sampling for controls | 30th and 50th minute |
| Glass fed in during the entire test kg | 91.1 |
| Glass discharged kg | 88.8 |
| Glass recovered % | 97.48 |
| Quality of the glass produced | The glass was very clean, not containing extraneous substances and silicon was absent |
| Condition of the back sheet (Tedlar®) | Moderately hot with physical characteristics (viscosity) not such as to compromise operation |
| Production of glass from the prototype kg/h | 90 kg/hour equivalent to 2.16/tonnes/day |

These results show:
- The very good quality level of the glass produced, virtually free from metallic silicon.
- The condition of the back sheet, which did not compromise continuity of removal.
- The very high yield due to the ease of removal and the possibility of controlling the position of the chisel behind the EVA.

Table 2 below shows the results of the particle size analyses performed on the samples.

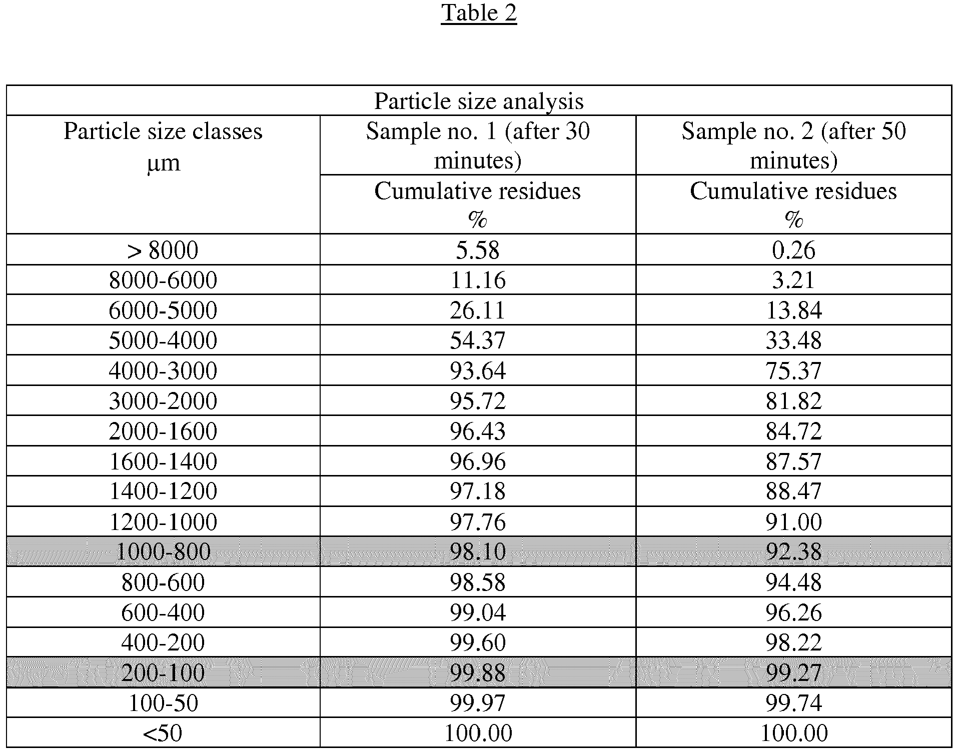

These results show the very constant particle size of the glass obtained over time, approximately 90% of which has dimensions >800 microns, with the fraction <200 microns being of the order of 1%, which makes it suitable for quantitative use in hollow and flat glass glassworks.

### Example 2

Again in this case a suitable number of panels without the aluminium frames were used, and from these approximately 30 strips having the following dimensions, 135 cm x 25 cm, were obtained. Of these 27 were bonded head-to-tail to obtain a continuous strip of approximate length 36.5 m which guaranteed continuity of operation of the order of 60 minutes.

The end-of-life photovoltaic panels used for Example no. 2 were characterised by glass having a low concentration of Fe₂O₃ (<0.02%), and therefore very low absorbance of infrared light in the range 1000-2500 nm and given the smaller thickness in comparison with that in the previous example (2.8 mm instead of 4.0 mm), also lower than in the previous example.

Heating the aforesaid strip with IR lamps of suitable power controlled by an algorithm controlling the thermal energy delivered and the temperature of the EVA and the glass it was possible to maintain favourable extraction conditions, also with action on the system's feed rate, which also in this case made it possible to achieve the following benefits:
- To make use of the high transmittance of the glass to the underlying layer of EVA, raising it to the temperature of 105°C ± 2°C at which it is possible to make use of the residual thermoplasticity of the EVA without initiating completion of the cross-linking which begins around 145°C. In this case however the lesser thickness of the glass did not make it possible to maintain the gradient between the temperature of the EVA and that of the glass within optimum levels, but it was possible to bring the experiment to a conclusion, although operating at more critical levels.
- To maintain a gradient of 15°C between the temperature of the EVA and the overlying glass (EVA 105 - glass 85-90°C) which nevertheless made it possible to favour removal of the glass from the EVA and reduce the extremely harmful carry-over of metallic silicon particles into the recovered glass. This disadvantage can be overcome by providing more space to increase the speed of transit of the panel below the IR lamps in the system control algorithm.
- To contain the excessive heating of the back sheet which in all its versions is a thermoplastic material and can curl up creating harmful stoppages. Again this difficulty, although small, as shown by the characteristics of the glass recovered, could in an industrial context be restored to normal by widening the field of action of the control algorithm.

The following results were obtained under these conditions:
1. A test was carried out for slightly more than 60 minutes feeding all 36.5 m of the strip in the manner described above.
2. Temperature variations of the glass of the maximal order of 5° (90°C minimum and 95°C maximum) were recorded during the period, while those of the EVA below the glass were kept within the range specified, apart from maximum variations of the order of 5°C (105°C minimum and 110°C maximum), achieving a gradient of the order of only 15°C. Despite the net reduction in the gradient no disadvantages such as to interrupt the operability of the system were observed.
3. The strip fed in contained 63.8 kg of glass, while in the course of the entire test 61.6 kg of this were recovered, a yield of the order of 96.55%.

Two samples were taken during the course of the period, the first after approximately 30 minutes operation of the prototype and the second after 50 minutes.

The results for Example no. 2 are shown in Table 3 below.

**Table 3**

| Results obtained | |
|---|---|
| Length of the photovoltaic strip m | 36.5 |
| Temperature of the EVA + silicon °C | 105-110°C |
| Temperature of the glass °C | 90-95°C |
| Gradient between the two temperatures °C | 15-25°C |
| Duration of the test minutes | 62 |
| Sampling for controls | 30th and 50th minute |
| Glass fed in during the entire test kg | 63.8 |
| Glass discharged kg | 61.6 |
| Glass recovered % | 96.55 |
| Quality of the glass produced | The glass was very clean, not containing extraneous substances and traces of silicon |
| Condition of the back sheet (Tedlar®) | Hot with physical properties (viscosity) which were still not critical |
| Production of glass from the prototype kg/h | 63.8 kg/hour, equivalent to 1.53/tonnes/day |

These results show:
- The very good quality level of the glass produced, virtually free from metallic silicon.
- The condition of the back sheet, which although heated to higher temperatures with more critical softening made separation more critical without compromising continuity.
- Yield was high, although approximately 1% less than in Example no. 1 because of the ease of separation and the possibility of controlling the position of the heated chisel behind the EVA.

Table 4 below shows the results of the particle size analyses performed on the samples.

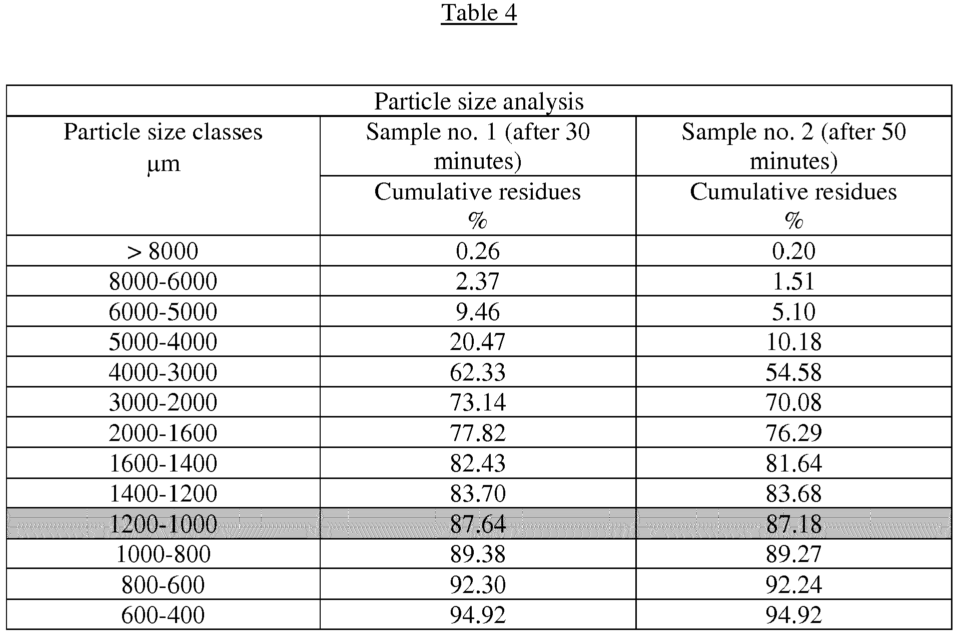

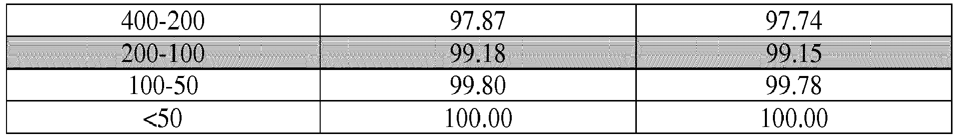

Again in this case the particle size of the glass was very constant over time in that 90% had dimensions >800 microns with the <200 micron fraction of the order of 1%, which allows it to be used quantitatively in hollow and flat glass glassworks.

## Claims

1. Method for separating glass from a photovoltaic panel laminate, said laminate comprising an encapsulating layer (3) of partially cured ethylene vinyl acetate, EVA, containing photovoltaic cells of mono- or polycrystalline metallic silicon, a front plate (5) of glass and a back sheet (7) bonded to said encapsulating layer on opposite surfaces thereof, **characterized by** comprising the steps of:
heating the laminate (1) by means of infrared heaters (R1, R2) to bring EVA to a working temperature comprised between 70 and 150°C, preferably between 100 and 110°C, to cause EVA to soften; and
detaching glass from the encapsulating layer (3) heated to the working temperature.

2. Method according to claim 1, wherein said heaters emit infrared radiation of wavelength comprised between 1000 e 2500 nm, with respect of which glass of the front plate (5) is transparent.

3. Method according to claim 1 or 2, wherein the laminate (1) is caused to advance along an advance direction (y) parallel to its faces, and heating of laminate (1) and detaching of glass are carried out while the laminate (1) advances along the advance direction (y).

4. Method according to claim 3, wherein the advance speed of the laminate (1) and/or emission of the infrared heaters (R1, R2) are adjusted to have, during detaching of the glass, a temperature gradient between the opposite faces of the laminate comprised between 5 and 35°C, preferably between 15 and 25°C, temperature of the glass-side face being lower than temperature of back sheet-side face of the laminate.

5. Method according to claim 3 or 4, wherein detaching of glass is carried out by means of a chisel (C) cutting head-on into the laminate (1) and reciprocatingly movable in a direction parallel to the advance direction (y) of the laminate (1).

6. Method according to claim 5, wherein the cutting edge (C1) of the chisel (C) is positioned, with respect to thickness direction of the laminate (1), within the thickness range of glass and close to interface (9) between glass and EVA.

7. Apparatus for carrying out a method according to any of the preceding claims.
